# EUROPEAN PATENT APPLICATION

(11) **EP 2 914 071 A1**
(43) Date of publication of application: **02.09.2015**
(21) Application number: 14157255.2
(22) Date of filing: 28.02.2014
(51) Int. Cl.: H05K 1/02, H05K 1/03

(54) **Heat spreader in multilayer build ups**

(71) Applicant: AT & S Austria Technologie & Systemtechnik Aktiengesellschaft, 8700 Leoben-Hinterberg (AT)
(72) Inventor: Kreutzwiesner, Elisabeth, 8020 Graz (AT); Schulz, Gernot, 8020 Graz (AT)
(74) Representative: Patentanwaltskanzlei Matschnig & Forsthuber OG

(57) **Abstract**

Connection system (1) for electronic components, the connection system (1) comprising at least one electrically insulating layer (4a', 4a", 4b', 4b") and at least one electrically conductive layer (3a, 6a, 3b, 6b), wherein the connection system (1) further comprises a heat distributing layer (5a, 5b) arranged within the at least one electrically insulating layer (4a', 4a", 4b', 4b"), wherein the at least one heat distributing layer (5a, 5b) is made of thermally conductive, and electrically insulating, matrix-free material.

## Description

### Field of the invention and description of prior art

The present invention relates to a connection system for electronic components, the connection system comprising at least one electrically insulating layer and at least one electrically conductive layer. Furthermore, the present invention relates to a method for producing a connection system.

The invention relates to connection systems for electronic components in general, wherein electronic components such as transistors, integrated circuits (chips) and the like are arranged on or within a panel carrying and electrically connecting electronic components. Such panels are typically embodied as part of a printed circuit board. Alternatively, these carrying panels can be panels made of glass or any other insulating material suited to form a carrying panel. For the sake of simplicity, the description refers mostly to printed circuit boards. The person skilled in the art will, however, appreciate that whenever reference is made to printed circuit boards, also other connection systems for electronic components, such as substrates, interposers, redistribution layers and the like shall be encompassed by the present description and by the present invention.

The state of the art and its drawbacks are discussed in the following based on the example of a printed circuit board.

Printed circuit boards (PCBs) also referred to as printed wire boards are panels carrying and electrically connecting electronic components such as transistors and the like, and hence, form vital parts of electronic products. Printed circuit boards have a more or less complex structure depending on the specific application. In general a printed circuit board comprises a plurality of alternately arranged conductive layers and insulating layers bonded together by hardening panels of glass fibres impregnated with organic resin, said panels forming the insulating layers. Such panels for use in the production of printed circuit boards are widely known in the industries as "prepregs" (preimpregnated fibres), which are delivered and processed in an uncured, hence viscous state of the organic resin. The actual insulating layer results when the organic resin has cured. The insulating layers carry conductive layers, for example formed of copper foil, the conductive layers being appropriately processed to form wirings to electrically connect the electronic components. Modern printed circuit boards allow for a high degree of integration of electronic components and their appropriate wiring.

There is, however, a constant need for further miniaturization in the electronic industry in order to provide consumers and professionals with ever smaller yet more capable electronic devices and installations which require more electronic components to be packaged in a smaller space, leading to higher density of interconnection, multilayer build ups and active and passive component embedding, thus increasing the energy consumption and causing hot spots on a PCB. As heat affects the life time of components tremendously thermal management (in particular distribution of heat and cooling of components) of the PCB becomes increasingly important and a plurality of measures have been developed to control the temperature of components fixed on a PCB. A common measure to control the temperature of components is provided by passively or actively cooling the components by a cooling element mounted on the surface of the components. These cooling elements are preferably having an enlarged surface and are made of aluminum, copper or other materials having a high thermal conductivity. Additionally, cooling elements can be provided with cooling fans allowing an increased control of the cooling performance of the cooling element. This measurements are in fact very effective but do require considerable amount of space and add to the weight of the components, thus limiting its applicability in a plurality of electronic devices, such as mobile devices and in particular smart phones for instance.

### Summary of the invention

An object of the present invention is to provide a connection system for electronic components having an enhanced thermal management allowing further miniaturization and increasing the lifetime of components.

A further aspect of the present invention is to provide a method for producing a connection system for electronic components having an enhanced thermal management allowing further miniaturization and increasing the lifetime of components.

Thus, a first aspect of the present invention relates to a connection system for electronic components, the connection system comprising at least one electrically insulating layer and at least one electrically conductive layer, wherein the connection system further comprises a heat distributing layer arranged within the at least one electrically insulating layer, wherein the at least one heat distributing layer is made of thermally conductive and electrically insulating, matrix-free material.

By virtue of the features according to the invention it is possible to provide a highly effective and easily customizable and implementable thermal management allowing heat to be distributed within a connection system for electronic components. Therefore, the term "within" refers to an arrangement, in which the heat distributing layer is covered with electrically insulating material in a sandwich-like configuration. The heat distributing layer can be specifically designed for each connection system to meet the requirements of specific electronic devices, for instance by choice of its spatial dimensions. Thus, heat generated by components being mounted on the connection system and/or being in close proximity to the connection system can be distributed effectively. In the context of the present invention, all of these materials can be defined as being matrix-free. This means that these materials can be applied as pure substances without a matrix of solvents, dispersants, fillers, binders and the like. The use of such materials is particularly useful since these matrix-free, electrically insulating and thermally conductive materials, since they are pure substances, offer a relatively high thermal conductivity as compared to other electrically insulation, thermally conductive materials that can only be applied with the bulk of the materials forming the matrix. This enhances the lifetime of components. In case the electronic device being a mobile phone, the invention further allows to prevent the occurrence of hot spots on an outer (surface) layer of a mobile device, typically causing an uncomfortable "hot ear" during phone conversations. The present invention allows for an effective heat distribution of embedded components, which is otherwise very difficult, since embedded components, by definition, are embedded within a alyer of the connection system that is electrically and thermally insulating. By the provision of a heat distributing layer within an insulating layer this problem can effectively be overcome. Furthermore, the material in the heat distribution layer preferably has a low permittivity effectively minimizing capacitive leakage currents.

In a preferred embodiment the at least one heat distributing layer has a layer thickness up to a maximum of 10 µm.

Furthermore, in an advantageous realization of the invention the at least one heat distributing layer has a thermal conductivity of at least 0,8 W/mK, preferably of at least 10 W/mK and more preferably of at least 50 W/mK.

In a preferred embodiment of the invention the matrix-free material comprises at least one material selected from the group consisting of amorphous graphite-like material, nitrides and oxides or mixtures thereof. Such amorphous graphite-like material is known in the art as diamond-like carbon (DLC) and stands out for high thermal conductivity while at the same time being electrically insulating. Preferably, the oxides are selected from the group consisting of Al₂O₃ and CuO or mixtures thereof. In a further preferred embodiment of the invention the nitride is AlN.

Preferably, two, three or more heat distributing layers are arranged within the connection system, wherein each heat distributing layer is separated from an adjacent heat distributing layer at least by an electrically insulating layer. Also, further electrically conductive layers can be arranged within one or more separating electrically insulating layer. The heat distribution layer is electrically insulating and therefore allows a plurality of electrical contacts connecting through heat distribution layer without shortcutting these contacts. Furthermore, it is feasible to thermally connect electronic components such as integrated circuits producing considerable amounts of heat to a heat distributing layer by simple electrically conductive vias without shortcutting them.

In another development of the invention at least one thermally conductive via (vertical interconnect access) is arranged to connect at least one electrically conductive layer with at least one heat distributing layer. The via allows an efficient heat transfer from the electrically conductive layer (and in particular from components connected to the electrically conductive layer) to the heat distributing layer. The via can be electrically conductive or insulating. In a preferred embodiment of the invention two, three or more vias can connect one, two, three or more electrically conductive layers with one, two or more heat distributing layers.

In an advantageous realization of the invention at least one electrically conductive via is arranged to connect a first electrically conductive layer with at least a second electrically conductive layer, wherein the at least one electrically conductive via is in contact with the heat distributing layer. This allows an improved thermal management of the first and the second electrically conductive layers as well as an efficient electrical connection of the electrically conductive layers. Alternatively, two, three or more electrically conductive layers can be connected by one, two, three or more electrically conductive vias.

In a further development of the invention the first and the second electrically conductive layers are arranged as opposing surface layers of the printed circuit board.

In yet another development of the invention the at least one heat distributing layer is thermally connected to a cooling element. The cooling element can either be the housing of a mobile device, a heat sink made of metal, such as copper or aluminum (which can be equipped with a cooling fan to enhance the cooling performance) or the like.

In a preferred embodiment of the invention the connection system is a printed circuit board.

According to a particularly preferred embodiment of the present invention, an electronic component is connected to a heat distributing layer by means of an electrically conductive via. As described above, this represents a particularly advantageous embodiment of the present invention, wherein it is feasible to thermally connect electronic components such as integrated circuits producing considerable amounts of heat to a heat distributing layer by simple electrically conductive vias without shortcutting them. In this embodiment the electronic component can be comprised on the surface of the inventive connection system for electronic components or the electronic component is an embedded component, as it is envisaged according to a preferred embodiment of the present invention

A second aspect of the invention relates to a method for producing a connection system, the method comprising the steps of:
a) providing a ply of electrically insulating material,
b) depositing the heat distributing layer on the ply of electrically insulating material,
c) covering the heat distributing layer with electrically insulating material to arrange the heat distributing layer within an electrically insulating layer
d) applying an electrically conductive layer on the at least one electrically insulating layer.

Deposition of the heat distribution layer on the ply of electrically insulating material can be achieved by sputtering processes (for instance physical vapor deposition or arc evaporation) or by plasma-enhanced/plasma-assisted chemical vapor deposition.

A printed circuit board produced according to this method comprises
- at least one insulating layer,
- at least one electrically conductive layer, and
- at least one heat distributing layer arranged within the at least one electrically conductive layer, said heat distributing layer being made of matrix-free material, the matrix-free material being thermally conductive and electrically insulating.

In a further development of the method according to the invention the electrically insulating material covering the heat distributing layer in step c) is a further ply of electrically insulating material.

In an advantageous realization of the method according to the invention, in another step the at least one electrically insulating layer is cured, this step taking place after step c).

In a further development of the method according to the invention in step b) two, three or more heat distribution layers are deposited on a plurality of plies of electrically insulating material, in step c) each heat distributing layer is covered with an electrically insulating material, and in step d) at least one electrically conductive layer is applied on at least one electrically insulating layer.

### Brief description of the drawings

In the following, the present invention will be described in more detail with reference to an exemplary inventive embodiment (which is not to be construed as limitative) shown in the drawing, in which
- Fig. 1: shows a schematic cross-sectional view of a core of an exemplary PCB prepared for a multilayer build up, according to the invention
- Fig. 2a, Fig. 2b and Fig. 2c: show two alternative basic materials to be pressed on the PCB of Fig.1,
- Fig. 3: shows a schematic cross-sectional view of the PCB of Fig. 2a and accordingly Fig. 2c after deposition of heat distributing layers,
- Fig. 4: shows a schematic cross-sectional view of the PCB of Fig. 3 after pressing with further prepregs,
- Fig. 5: shows a schematic cross-sectional view of the PCB of Fig. 4 after drilling,
- Fig. 6: shows a schematic cross-sectional view of the PCB of Fig. 5 after copper plating,
- Fig. 7: shows a schematic cross-sectional view of the PCB of Fig. 6 after photolithographic processing, and
- Fig. 8: shows a preferred embodiment of the present invention, in which electronic component is connected to a heat distributing layer by means of an electrically conductive via.

### Detailed description of the invention

Embodiments of a connection system according to the invention as well as a method for producing the same will be described below in more detail with reference to the accompanying drawings. For same or similar components same reference numerals are used in order to avoid redundant explanations. The connection systems described in the exemplary embodiment is a printed circuit board. Of course, the connection system is not limited to PCBs but could also relates to other carrier planes (for example glass) in general not referred to as PCBs but being suited to provide an electrically insulating layer and at least one electrically conductive layer.

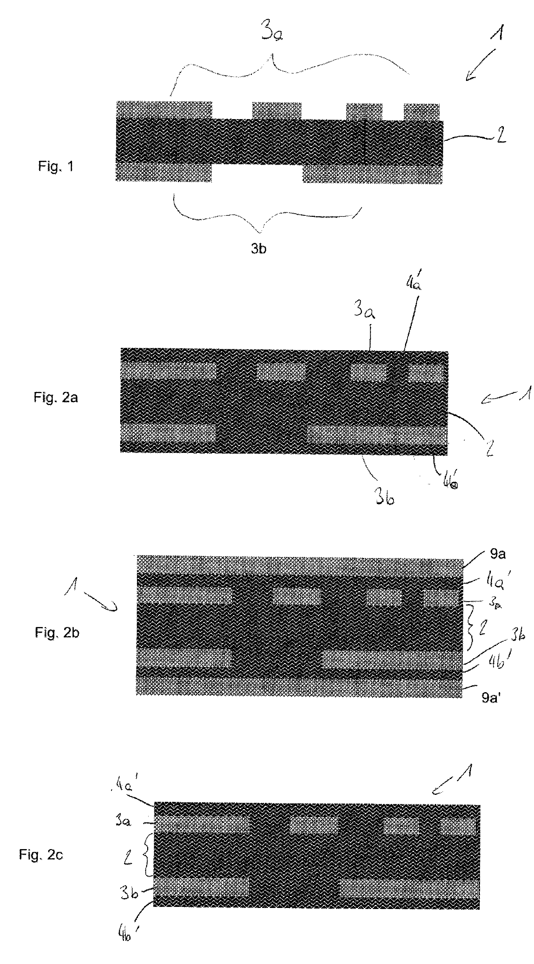

Fig. 1 shows a schematic cross-sectional view of a core of an exemplary PCB 1 prepared for a multilayer build up in a basic configuration. The PCB 1 according to Fig. 1 comprises an insulating layer 2, typically made of resin, and two structured conductive layers 3a and 3b, arranged on opposing sides of the insulating layer 2. The conductive layers 3a and 3b are for instance made of copper, preferably copper foils, the conductive layers being appropriately processed to form wirings to electrically connect electronic components.

Fig. 2a, Fig. 2b and Fig. 2c show two additional basic materials/prepregs to be pressed/laminated on the PCB 1 of Fig.1 in order to achieve a multilayer build up. In particular, Fig. 2a discloses a configuration, in which each conductive layer 3a and 3b is covered with plies 4a' and 4b' of electrically insulating material, each ply being part of an electrically insulating layer, the plies being preferably prepregs made of resin. The plies 4a', 4b' can be mounted on the PCB 1 by pressing/laminating methods as known to the person skilled in the art. Fig. 2b shows plies 4a' and 4b' and electrically conductive layers 9a and 9b mounted on the plies 4a' and 4b', wherein the electrically conductive layers 9a and 9b are then removed according to Fig. 2c. Adding in a first step the electrically conductive layers 9a and 9b and removing the electrically conductive layers 9a and 9b in a following step allows the use of standard mass production processes, wherein the plies 4a' and 4b' are usually covered with electrically conductive layers as shown in Fig. 2b.

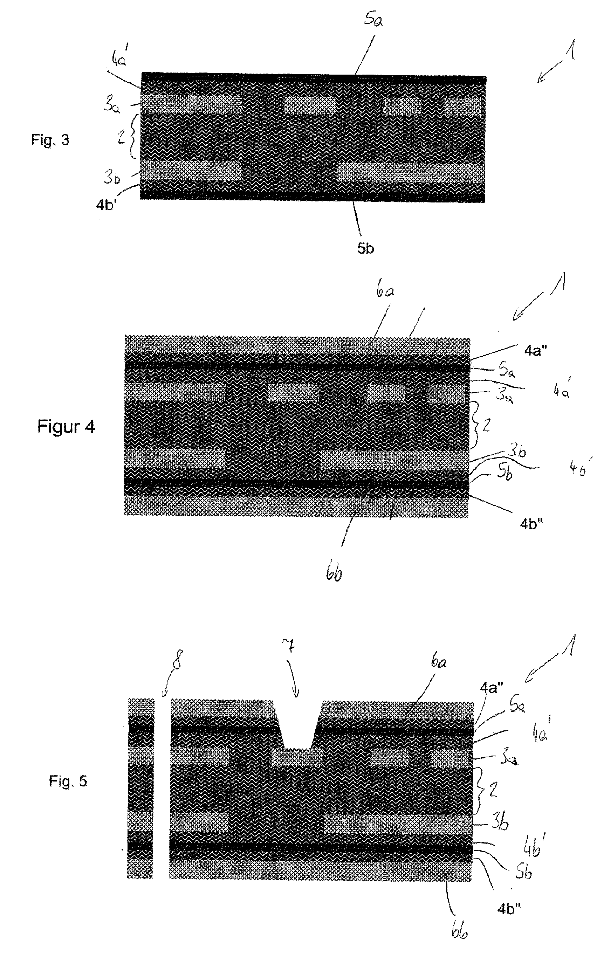

Fig. 3 shows a schematic cross-sectional view of the PCB 1 of Fig. 2a and accordingly Fig. 2c after deposition of heat distributing layers 5a and 5b. The heat distributing layers 5a and 5b are deposited on the electrically insulating plies 4a', 4b' by sputtering processes (for instance physical vapor deposition or arc evaporation) or by plasma-enhanced/plasma-assisted chemical vapor deposition.

Fig. 4 shows a schematic cross-sectional view of the PCB 1 of Fig. 3 after pressing/laminating of further electrically insulating plies 4a", 4b" (preferably made of resin) covered with electrically conductive layers 6a, 6b on the respective heat distributing layer 5a, 5b, wherein each ply 4a", 4b" is preferably a prepreg made of resin. Therefore, an electrically insulating layer, having a heat distributing layer 5a, 5b arranged within the electrically insulating layer is realized by the combination of the plies 4a' and 4a" as well as 4b' and 4b". Thus, Fig. 4 shows a PCB having two insulating layers having heat distributing layers 5a and 5b according to the invention arranged within electrically insulating layers. The heat distributing layers 5a, 5b are made of matrix-free material, the matrix-free material being thermally conductive and electrically insulating. The electrically conductive layers 6a, 6b are preferably made of copper foil. In an alternative embodiment of the invention, the electrically insulating plies 4a" and 4b" are replaced by other means for insulating the heat distributing layers 5a and 5b. This might be realized by resin coatings or any other electrically insulating coating.

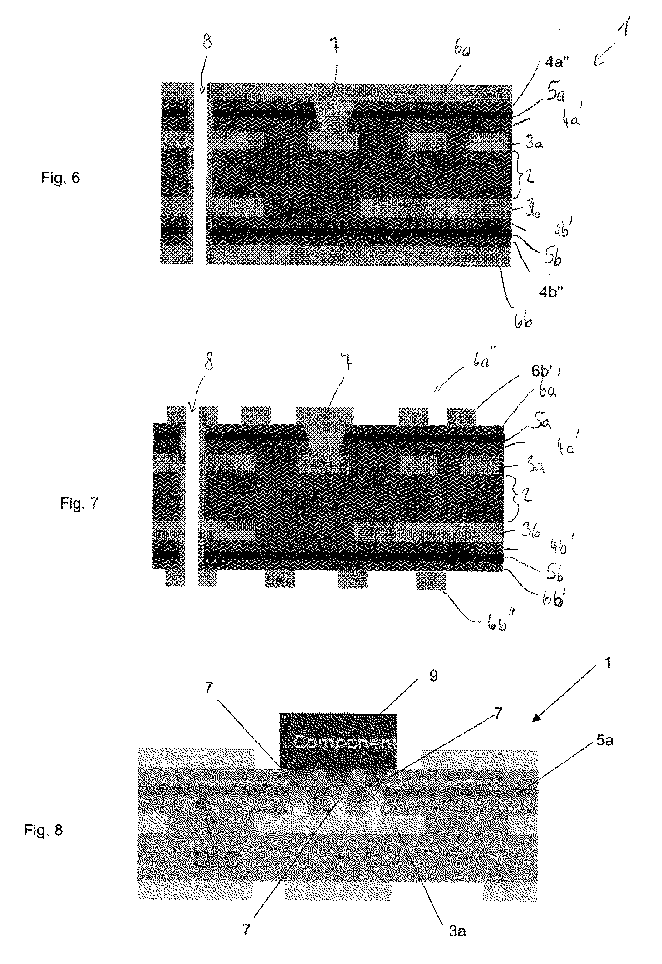

Fig. 5 shows a schematic cross-sectional view of the PCB 1 of Fig. 4 after a drilling process, wherein the PCB 1 shows two exemplary openings, each created by laser drilling and/or mechanical drilling. The PCB 1 holds a vertical interconnection access (via) 7, which is filled with copper (see Fig. 6) and therefore allows an improved thermal connection of the electrically conductive layer 6a with the heat distributing layer 5a. Next to the via 7 there is an exemplary through-hole, the through-hole 8 being arranged to electrically connect electrically conductive layers of choice.

Fig. 6 shows a schematic cross-sectional view of the PCB 1 of Fig. 5 after copper plating (which can be achieved current-free and afterwards galvanically, for instance). Finally, the electrically conductive layers 6a and 6b can be structured/patterned by applying conventional methods like photolithographic and etching processes, resulting in the PCB 1 as shown in Fig. 7. As a result, electronic components mounted and/or electrical connected to any of the electrically conductive layers 6a, 6b, ly and/or 3b can be cooled effectively by distributing the heat by means of the heat distributing layers 5a and 5b.

The PCB 1 in Fig. 7 illustrates one exemplary embodiment of a PCB according to the invention, having two separated heat distributing layers 5a and 5b. Thus, the electrically insulating plies 4a' and 4a" together form one insulating layer in the sense of the invention, wherein the heat distributing layer 5a is arranged within this electrically insulating layer. Correspondingly, the heat distributing layer 5b is arranged within an electrically insulating layer, comprising the electrically insulating plies 4b' and 4b".

It should be noted that Figures 1 to 7 refer to a multilayer built up of a PCB, wherein a plurality of heat distributing layers are arranged within the PCB. Also, the heat distributing layers can be limited to specific areas within an electrically insulating layer. Obviously, the invention can be arranged differently, for example in the core of a PCB and/or section wise within given layers. The invention is not limited to the examples given in this specification and can - in view of this disclosure - be adjusted in any manner known to a person skilled in the art.

In Fig. 8 an electronic component 9 is arranged on the PCB 1 and is connected to a heat distributing layer 5a by means of an electrically conductive via 7. The via 7, in this embodiment reaches through the heat distributing layer 5a down to electrically conductive layer 3a. Hence, in this embodiment, the via 7 provides for thermal connection of the component 9 to a heat distributing layer 5a as well as to an electrically conductive layer 3a without shortcutting the component 9 by the heat distributing layer 5a. In accordance with a preferred embodiment of the present invention, the component 9 could also be an embedded component.

## Claims

1. Connection system (1) for electronic components, the connection system (1) comprising at least one electrically insulating layer (4a', 4a", 4b', 4b") and at least one electrically conductive layer (3a, 6a, 3b, 6b),
**characterized in that**,
the connection system (1) further comprises a heat distributing layer (5a, 5b) arranged within the at least one electrically insulating layer (4a', 4a", 4b', 4b"), wherein the at least one heat distributing layer (5a, 5b) is made of thermally conductive and electrically insulating, matrix-free material.

2. Connection system (1) according to claim 1, **characterized in that** the at least one heat distributing layer (5a, 5b) has a layer thickness up to a maximum of 10 µm.

3. Connection system (1) according to claim 1 or 2, **characterized in that** the at least one heat distributing layer (5a, 5b) has a thermal conductivity of at least 0,8 W/mK, preferably of at least 10 W/mK and particularly preferred of at least 50 W/mK.

4. Connection system (1) according to any of the preceding claims, **characterized in that** the matrix-free material comprises at least one material selected from the group consisting of amorphous graphite-like material, nitrides and oxides or mixtures thereof.

5. Connection system (1) according to claim 4, **characterized in that** the oxides are selected from the group consisting of Al₂O₃ and CuO or mixtures thereof.

6. Connection system (1) according to claim 4 or 5, **characterized in that** the nitride is AlN.

7. Connection system (1) according to any of the preceding claims, **characterized in that** two, three or more heat distributing layers (5a, 5b) are arranged within the connection system (1), wherein each heat distributing layer (5a, 5b) is separated from an adjacent heat distributing layer (5a, 5b) at least by an electrically insulating layer (4a', 4a", 4b', 4b").

8. Connection system (1) according to any of the preceding claims, **characterized in that** at least one thermally conductive via (7) is arranged to connect at least one electrically conductive layer (3a, 6a, 3b, 6b) with at least one heat distributing layer (5a, 5b).

9. Connection system (1) according to any of the preceding claims, **characterized in that** at least one electrically conductive via (3a, 6a, 3b, 6b) is arranged to connect a first electrically conductive layer (3a, 6a, 3b, 6b) with at least a second electrically conductive layer (3a, 6a, 3b, 6b), wherein the at least one electrically conductive via (7) is in contact with the heat distributing layer (5a, 5b).

10. Connection system (1) according to any of the preceding claims, **characterized in that** the at least one heat distributing layer (5a, 5b) is thermally connected to a cooling element.

11. Connection system (1) according to any of the preceding claims, **characterized in that** the connection system (1) is a printed circuit board.

12. Connection system (1) according to any of the preceding claims, **characterized in that** an electronic component (9) is connected to a heat distributing layer (5a, 5b) by means of an electrically conductive via (7).

13. Connection system according to claim 12, **characterized in that** the electronic component (9) is an embedded component.

14. Method for producing a connection system (1) according to any of claims 1 to 13, the method comprising the steps of:
a) providing a ply (4a', 4b') of electrically insulating material,
b) depositing the heat distributing layer (5a, 5b) on the ply (4a', 4b') of electrically insulating material,
c) covering the heat distributing layer with electrically insulating material to arrange the heat distributing layer within an electrically insulating layer
d) applying an electrically conductive layer (6a, 6b) on the at least one electrically insulating layer.

15. Method according to claim 14, wherein the electrically insulating material covering the heat distributing layer in step c) is a further ply (4a", 4b") of electrically insulating material.

16. Method according to claim 14 or 15, wherein after step c) the at least one electrically insulating layer is cured.

17. Method according to any of the claims 14 to 16, wherein in step b) two, three or more heat distribution layers (5a, 5b) are deposited on a plurality of plies of electrically insulating material, in step c) each heat distributing layer is covered with an electrically insulating material, and in step d) at least one electrically conductive layer is applied on at least one electrically insulating layer.
